Europäisches Patentamt

European Patent Office

Office européen des brevets

(11) Veröffentlichungsnummer: **0 363 713**
**A1**

(12) **EUROPÄISCHE PATENTANMELDUNG**

(21) Anmeldenummer: **89117624.0**

(22) Anmeldetag: **23.09.89**

(51) Int. Cl.⁵: **B23K 3/04 , H05K 13/04**

(30) Priorität: **06.10.88 CH 3717/88**

(43) Veröffentlichungstag der Anmeldung:
**18.04.90 Patentblatt 90/16**

(84) Benannte Vertragsstaaten:
**AT BE CH DE ES FR GB GR IT LI LU NL SE**

(71) Anmelder: **ROSSELL ELECTRONIQUE S.A.**
**Fährhütte**
**CH-9477 Trübbach(CH)**

(72) Erfinder: **Zeltner, Viktor**
**Joachimsbüel**
**CH-9475 Sevelen(CH)**

(74) Vertreter: **Troesch, Jacques J., Dr. sc. nat. et al**
**Walchestrasse 19**
**CH-8035 Zürich(CH)**

(54) **Elektrode für einen elektrisch beheizten Lötkopf einer Lötmaschine.**

(57) Die Elektrode für einen elektrisch beheizten Lötkopf einer Lötmaschine weist ein stromdurchflossenes einen Heizwiderstand bildendes Element (16) und ein, zum Aufliegen auf dem Lötgut vorgesehenes Organ (19) auf. Das Element (16) und das Organ (19) werden wärmeleitend verbunden und letzteres wird auf dem Potential des Lötgutes gehalten. Das stromdurchflossene, einen Heizwiderstand bildende Element (16) ist von einem, zum Aufliegen auf dem Lötgut vorgesehenen Organ (19) durch eine elektrisch isolierende thermisch durchlässige Schicht (17) getrennt. Dies minimiert die elektrische Beeinflussung des Lötgutes durch das Organ (19), wobei die das Lötgut berührende Fläche des Organs (19) z.B. geerdet ist. Zum elektrischen Isolieren dient keramisches Material, Glimmer, ein Kunststoff oder ein Kleber auf Keramikbasis. Diese Elektrode für einen elektrisch beheizten Lötkopf einer Lötmaschine ermöglicht die Einhaltung der vorgeschriebenen maximalen Spannungen.

Fig. 1

## Elektrode für einen elektrisch beheizten Lötkopf einer Lötmaschine

Die vorliegende Erfindung betrifft eine Elektrode für einen elektrisch beheizten Lötkopf einer Lötmaschine.

Bei bekannten Stempellötgeräten hängt die Anzahl der vorzusehenden Elektroden von der Art des zu verlötenden Bauteiles ab. Die Stromzuführung zum Erhitzen der Lötflächen erfolgt über einen insbesondere der Halterung der Elektroden dienenden Kollektor auf die Elektroden. Dabei werden die Elektroden durch kurzzeitige hohe Ströme in Form einer Widerstandsheizung erhitzt. Die Spannung an den Elektroden gegenüber Erde ist undefiniert und kann mehrere Volt betragen. Dadurch können Bauteile und Leiterzüge beschädigt werden. Ein Erden der Elektroden ist nicht möglich, ebenso wenig in Verbindung mit einem Bezugspotential. Denn diese Massnahme würde bewirken, dass die Potentialdifferenz über der Elektrode durch eine derart geerdete Kontaktfläche kurzgeschlossen würde.

Die heutzutage vorgeschriebenen sehr geringen zulässigen Mittelwerte von Spannungen (RMS) von einigen, beispielsweise 2 Millivolt an Lötflächen derartiger Lötköpfe, sind mit den herkömmlichen, bisher bekannten Stempellötgeräten nicht erreichbar.

Die vorliegende Erfindung bezweckt die Schaffung einer Elektrode für einen elektrisch beheizten Lötkopf einer Lötmaschine, deren Konstruktion die Einhaltung der vorgeschriebenen maximalen Spannungen im vorer wähnten Sinne ermöglicht.

Eine derartige Elektrode zeichnet sich durch den Wortlaut einer der Ansprüche aus.

Die Erfindung wird anschliessend beispielsweise anhand einer Zeichnung erläutert.

Es zeigen in rein schematischer Darstellung:

Fig. 1 eine schematische perspektivische Darstellung eines Teils einer Stempellötvorrichtung,

Fig. 2 - 4 verschiedene Ausführungen von Heizelektroden in perspektivischer Darstellung zur Verwendung in der Vorrichtung gemäss Fig. 1,

Fig. 5 eine andere Ausführung einer Vorrichtung analog Fig. 1,

Fig. 6 die Lötvorrichtung nach Fig. 1 beim Löten eines IC.

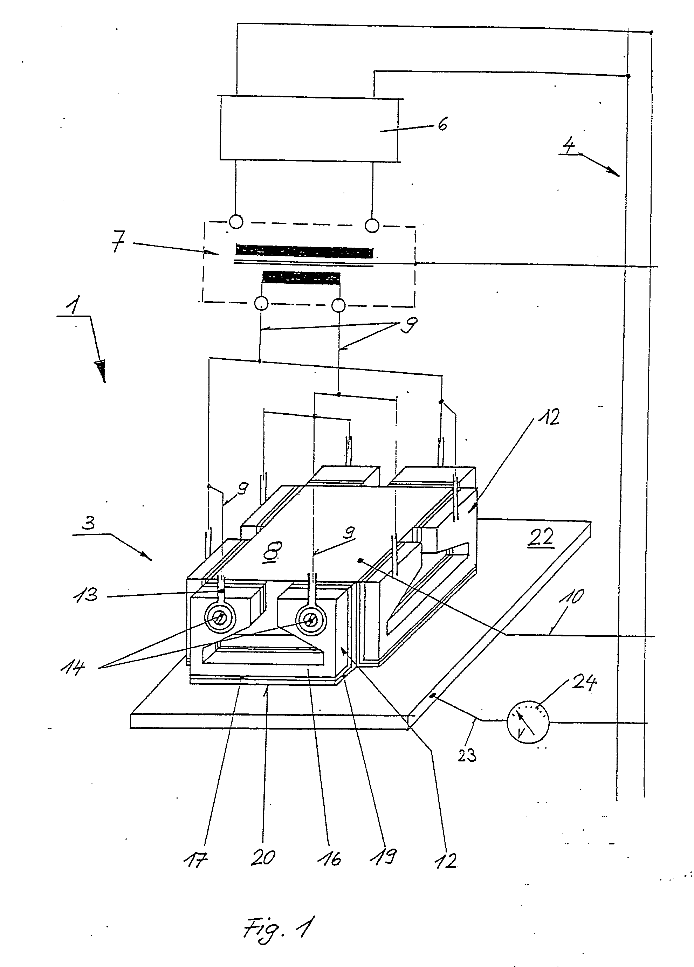

Fig. 1 zeigt einen Teil einer Lötvorrichtung 1 mit einem Vorderteil 3 eines Lötkopfes. Die Speisung zur Wärmeerzeugung erfolgt über eine Stromversorgerleitung 4 mit einem Erdleiter E, einem Nulleiter N und einem Phasenleiter L. Zu einer derartigen Vorrichtung gehört eine Ansteuerelektronik 6 sowie ein mit dieser verbundener Transformator 7, dessen Speisung primärseitig durch die Stromversorgerleitung 4 erfolgt. Der Sekundärteil des Transformators 7 führt über Heizleitungen 9, auf Heizelektroden 12, welche an einer Kollektorplatte 8 mittels Befestigungsschrauben 14 gehaltert sind. Die Kollektorplatte 8 ist mit einer Erdung 10 versehen. Die Speisung kann auch durch Drehstrom erfolgen.

Die Heizleitungen 9, wie ersichtlich, parallel (oder in Serie) geschaltet, führen über Kabelschuhe 13, die mittels der Befestigungsschrauben 14 mit den Heizelektroden 12 verbunden sind, die nötige Heizenergie zu, wobei die Befestigungsschrauben 14 elektrisch von den Heizelektroden 12 isoliert sind.

Die Heizelektroden 12 setzen sich aus einem Widerstandsheizjoch 16, welches durch den elektrischen Strom erhitzt wird, aus einem elektrischen Isoliermaterial 17, welches tunlichst gut wärmeleitend ist sowie einer Lötkontaktschiene 19 zusammen. Diese Schiene weist eine Lötkontaktfläche 20 auf.

In Fig. 1 ist eine Leiterplatte 22 bekannter Art dargestellt. Zwischen dieser und den Lötkon taktflächen 20 der Lötkontaktschienen 19 befinden sich die zu verlötenden Teile. Dabei wird heute von den staatlichen Instanzen verlangt, dass die über einen Erdmessleiter 23 und einem Messinstrument 24 geerdete Messplatte 22 eine Spannung von höchstens 2 Millivolt aufweist (RMS). Diese geringe Spannung wird durch das elektrisch isolierende Isoliermaterial 17 erreicht. Es hat sich gezeigt, dass die Lötkontaktschiene 19 und das Isoliermaterial 17 aus unterschiedlichen Materialien, d.h. als unterschiedliche Teile ausgebildet sein können. So können die Lötkontaktschienen 19 aus Stahl, Titan u. dgl. sein, während als Isolation Keramik, Glimmer, "Teflon" o. dgl. Kunststoff als Einzelteil oder z.B. auf der Lötkontaktschiene aufgedampft oder aufgesprüht, Verwendung finden. Dabei ist es möglich, die Isolationsschicht, insbesondere bei sehr unterschiedlichen Ausdehnungskoeffizienten, mittels eines Netzes zu armieren. Die vorzugsweise Ausführungsform benützt zum Isolieren keramisches Material.

Eine weitere Möglichkeit besteht darin, dass die Lötkontaktschiene 19 bei der Kontaktfläche mit dem Widerstandsheizjoch 16 speziell behandelt wird, beispielsweise eine Aluminiumlötkontaktschiene bei dieser Fläche hart eloxiert wird. Dabei ist es ferner möglich, die Lötkontaktschienen 19 direkt mit dem geerdeten Kollektor 8 zu verbinden oder über einen Draht speziell zu erden.

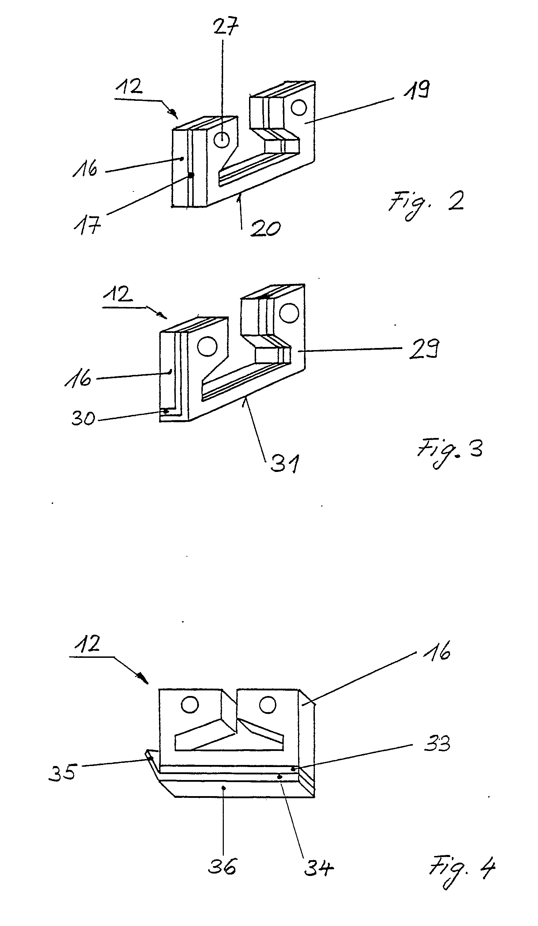

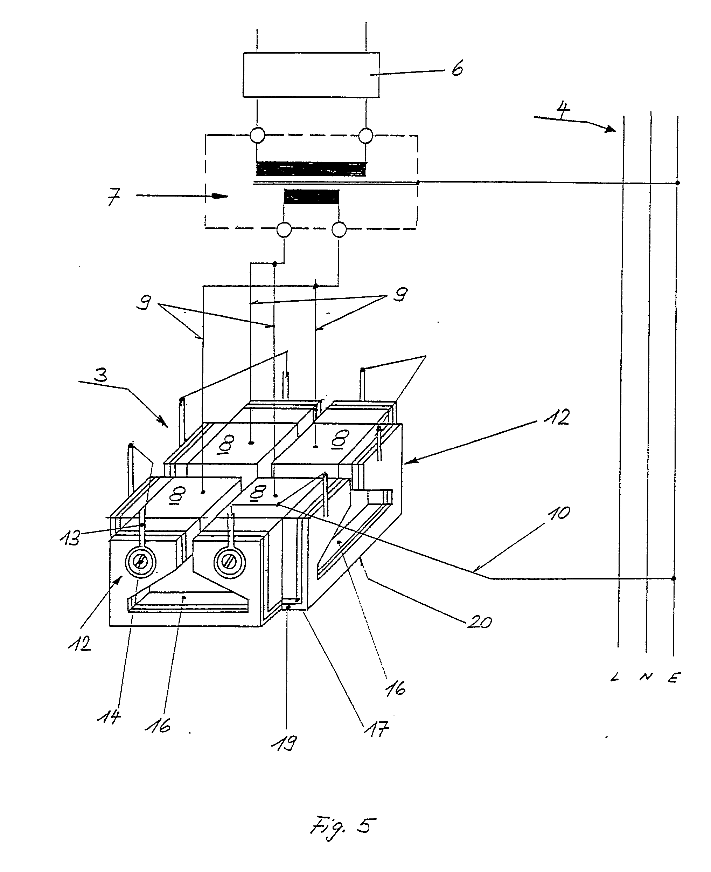

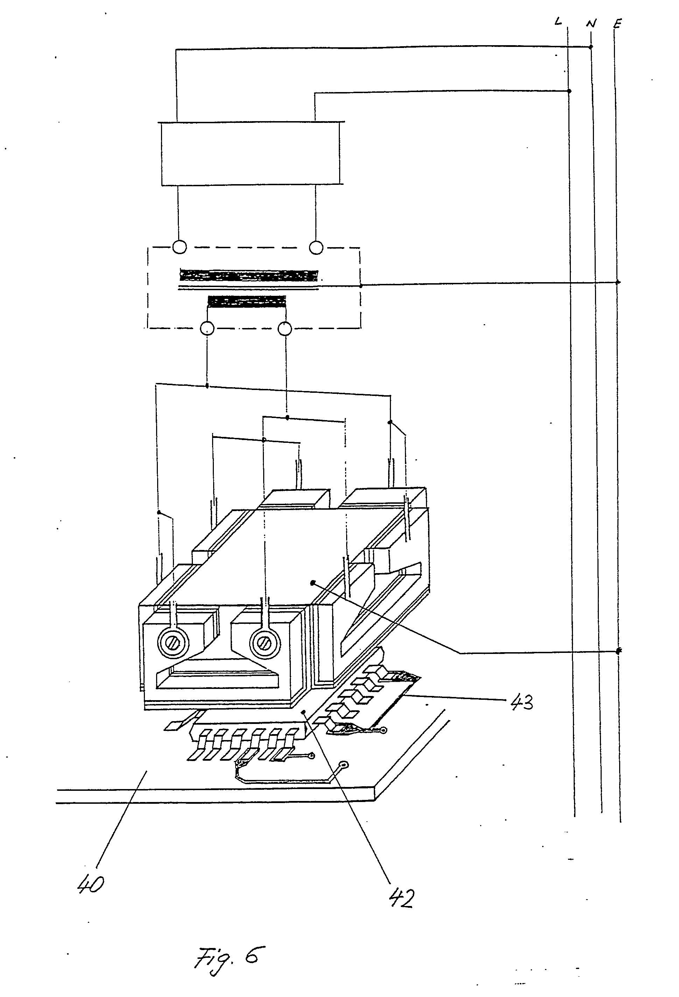

In den Fig. 2 bis 4 sind beispielsweise drei verschiedene Ausführungen von Heizelektroden 12 dargestellt, mit den entsprechenden Widerstandsheizjochen 16 und dem Isoliermaterial 17 bzw. den Isolationen 30 und 33 sowie den Lötkontaktschienen 19 mit den Lötkontaktflächen 20 bzw. Schienen 29 und Flächen 31 oder Kontaktschienen 34 mit Lötkontaktflächen 36.

Die normalerweise mit derartigen Lötmaschinen zu verlötenden Teile verlangen das grundsätzliche Erreichen der für das Löten nötigen Temperaturen an den Lötkontaktflächen, welche Temperaturen schnell zu erreichen und nach dem Löten ebenso schnell abgesenkt werden sollen, was durch entsprechend kleine zu erhitzende Massen erreicht wird. In diesem Sinne ist es auch möglich, die oberen Teile der Lötkontaktschiene 19 der Heizelektrode 12 im Bereich der der Befestigung dienenden Durchgänge 27 nicht nur elektrisch, sondern auch auch wärmemässig zu isolieren und nur den unteren Teil im Bereich der Lötkontaktfläche 20 der Lötkontaktschiene 19 elektrisch, jedoch nicht wärmetechnisch durch entsprechende Auswahl des Isoliermaterials zu isolieren. Das Isoliermaterial kann auch so beschaffen sein, dass zusätzlich eine magnetische Abschirmung des Lötbereiches erfolgt, z.B. durch zusätzliche Verwendung von u-Metall.

Die erwähnten Isolationsmassnahmen erlauben die Einhaltung der vorgeschriebenen maximalen Spannung der an Erde gelegten Leiterplatten.

Eine weitere Ausführung analog Fig. 1 ist in Fig. 5 dargestellt, wobei entsprechende Teile gleich bezeichnen sich. Die Stromanschlüsse sind unterschiedlich und die Kollektorplatte 8 besteht aus vier getrennten Teilen.

Fig. 6 zeigt die Vorrichtung nach Fig. 1 beim Löten eines auf einer Leiterplatte 40 plazierten IC 42. Eine Leiterbahn 43 verbindet zwei Kontaktschuhe.

Es wäre grundsätzlich möglich, auf eine gesonderte Lötkontaktschiene zu verzichten und direkt mit der Isolationsschicht den Lötvorgang zu vollziehen.

Bei diesen Vorrichtungen wird daher ein Beschädigen des Lötgutes durch Einwirkung elektrischer Ströme verhütet.

## Ansprüche

1. Elektrode für einen elektrisch beheizten Lötkopf (2) einer Lötmaschine, dadurch gekennzeichnet, dass sie ein stromdurchflossenes, einen Heizwiderstand bildendes Element (16) und ein, zum Aufliegen auf dem Lötgut vorgesehenes Organ (19) aufweist, wobei das Element (16) und das Organ (19) wärmeleitend verbunden werden und letzteres auf dem Potential des Lötgutes gehalten wird.

2. Elektrode, vorzugsweise nach mindestens einem der Ansprüche, dadurch gekennzeichnet, dass das stromdurchflossene, einen Heizwiderstand bildende Element (16) von einem, zum Aufliegen auf dem Lötgut vorgesehenen Organ (19) durch eine elektrisch isolierende, thermisch durchlässige Schicht (17) getrennt ist, zum Zwecke, die elektrische Beeinflussung des Lötgutes durch das Organ (19) zu minimieren, wobei die das Lötgut berührende Fläche des Organs (19) z.B. geerdet ist.

3. Elektrode, vorzugsweise nach mindestens einem der Ansprüche, dadurch gekennzeichnet, dass zum elektrischen Isolieren keramisches Material, Glimmer, ein Kunststoff oder ein Kleber auf Keramikbasis dient.

4. Elektrode, vorzugsweise nach mindestens einem der Ansprüche, dadurch gekennzeichnet, dass das Organ (19) Al aufweist, dessen am Heizelement (16) anliegender Teil harteloxiert ist, um als elektrisch isolierende Schicht zu dienen.

5. Elektrode, vorzugsweise nach mindestens einem der Ansprüche, dadurch gekennzeichnet, dass die Lötfläche (20) des Organs (19) in Arbeitslage zur Masse einen Spannungshöchstwert von 2 mV RMS (Effektivwert) aufweist.

6. Elektrode, vorzugsweise nach mindestens einem der Ansprüche, dadurch gekennzeichnet, dass die isolierende Schicht mindestens in Teilen armiert ist.

7. Elektrode, vorzugsweise nach mindestens einem der Ansprüche, dadurch gekennzeichnet, dass im Bereich des Organs (19) eine wärmeleitende, elektrisch isolierende Schicht und ausserhalb dieses Bereiches eine wärme- und elektrisch isolierende Schicht angeordnet ist.

8. Elektrode, vorzugsweise nach mindestens einem der Ansprüche, dadurch gekennzeichnet, dass auf das Organ (19) eine Isolierschicht, z.B. ein Kunststoff, aufgedampft oder gesprüht ist.

9. Lötkopf, gekennzeichnet durch mindestens eine Elektrode, vorzugsweise nach mindestens einem der vorangehenden Ansprüche.

Fig. 1

Fig. 2

Fig. 3

Fig. 4

Fig. 5

Fig. 6

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (Int. Cl.5) |
|---|---|---|---|
| Y | FR-A-2496519 (LES FABRIQUES D ASSORTIMENTS REUNIES) <br> * Seite 3, Zeile 26 - Seite 4, Zeile 24; Figur 1 * | 1 | B23K3/04 <br> H05K13/04 |
| Y | US-A-2359393 (SLOAN) <br> * Spalte 1, Zeile 31 - Spalte 2, Zeile 23; Figuren 1-3 * | 1 | |
| A | DE-A-3531715 (HANS WIDMAIER FABRIK FUR APPARATE DER FERNMELDE UND FEINWERKTECHNIK) <br> * Spalte 2, Zeile 24 - Spalte 8, Zeile 12; Figuren 1, 2 * | 1 | |

| | RECHERCHIERTE SACHGEBIETE (Int. Cl.5) |
|---|---|
| | H05K <br> B23K <br> H01R <br> H01L |

Der vorliegende Recherchenbericht wurde für alle Patentansprüche erstellt

| Recherchenort | Abschlußdatum der Recherche | Prüfer |
|---|---|---|
| DEN HAAG | 11 JANUAR 1990 | HERBRETEAU D. |